# EUROPÄISCHE PATENTSCHRIFT

(11) **EP 1 184 565 B1**
(45) Veröffentlichungstag und Bekanntmachung des Hinweises auf die Patenterteilung: **04.01.2006**
(21) Anmeldenummer: 01127970.0
(22) Anmeldetag: 23.03.1996
(51) Int. Cl.: F02M 61/18, B05B 1/34, F02M 61/16, F02M 51/06, C25D 1/10

(54) **Lochscheibe, insbesondere für Einspritzventile und Verfahren zur Herstellung einer Lochscheibe**
Perforated disk especially for injection valves and process for producing it
Disque perforé notamment pour injecteurs et son procédé de fabrication

(30) Priorität: 29.03.1995 DE 19511540; 27.02.1996 DE 19607266
(43) Veröffentlichungstag der Anmeldung: 06.03.2002
(62) Teilanmeldung aus: 96907267.7
(73) Patentinhaber: ROBERT BOSCH GMBH, 70442 Stuttgart (DE)
(72) Erfinder: Arndt, Stefan, 70569 Stuttgart (DE); Schatz, Franz, 70806 Kornwestheim (DE); Hahn, Dietmar, 70839 Gerlingen (DE); Fuchs, Heinz, 70469 Stuttgart (DE); Flik, Gottfried, 71229 Leonberg (DE); Dantes, Guenter, 71735 Eberdingen (DE); Moersch, Gilbert, 70563 Stuttgart (DE); Nowak, Detlef, 74199 Untergruppenbach (DE); Heyse, Joerg, 74354 Besigheim (DE); Ader, Beate, 71686 Remseck (DE)

(56) Entgegenhaltungen:
- EP-A- 0 354 660
- EP-A- 0 611 886
- WO-A-95/27136
- US-A- 4 826 131
- US-A- 4 934 653
- US-A- 5 383 597
- PATENT ABSTRACTS OF JAPAN vol. 010, no. 081 (M-465), 29. März 1986 (1986-03-29) & JP 60 222557 A (HITACHI SEISAKUSHO KK;OTHERS: 01), 7. November 1985 (1985-11-07)

## Beschreibung

### Stand der Technik

Die Erfindung geht aus von einer Lochscheibe, insbesondere für Einspritzventile, nach dem Oberbegriff des Anspruchs 1 bzw. von einem Verfahren zur Herstellung einer Lochscheibe nach dem Oberbegriff des Anspruchs 15.

Es ist bereits aus der EP-OS 0 354 660 bekannt, Düsen in Lochscheibenform zu fertigen, die sogenannte "S-Typ-Scheiben" darstellen. Damit ist gemeint, daß die Ein- und die Auslaßöffnungen in der Lochscheibe zueinander versetzt ausgebildet sind, wodurch sich zwangsläufig ein "S-Schlag" in der Strömung eines die Lochscheibe durchströmenden Fluids ergibt. Die vorgeschlagenen Lochscheiben werden von zwei ebenen, durch Bonden zusammengefügten Plättchen gebildet, die aus Silizium bestehen. An den Siliziumplättchen sind Bereiche reduzierter Dicke ausgeformt, so daß Scherspalte parallel zu den Stirnflächen der Plättchen zwischen den Öffnungen des ersten Plättchens und der einen Öffnung des zweiten Plättchens gebildet sind. Mit der bekannten Maskentechnik werden durch Ätzen auf Siliziumwafern, die eine Vielzahl von Lochscheibenstrukturen aufweisen, die Ein- und Auslaßöffnungen erzeugt. Die kegelstumpfförmigen Konturen für die Öffnungen in der Lochscheibe ergeben sich in logischer Weise aus der anisotropen Ätztechnik.

Eine Ventilanordnung, bestehend aus einem elastischen Siliziumventilplättchen und einem Düsenplättchen ebenfalls aus Silizium, ist schon aus der EP-OS 0 314 285 bekannt. Die beiden Siliziumplättchen sind miteinander verbunden und können relativ zueinander ausgelenkt werden. Im Siliziumventilplättchen sind Einlaßöffnungen vorgesehen, die mit einem Versatz zu Auslaßöffnungen im Düsenplättchen angeordnet sind. Im geschlossenen Zustand der Ventilanordnung dichten Plateauflächen des Siliziumventilplättchens die Auslaßöffnungen im Düsenplättchen ab, während bei einem Verbiegen des Düsenplättchens mittels eines Betätigungsgliedes ein S-förmiger Durchgang für ein Fluid entsteht und die Ventilanordnung geöffnet ist.

Aus der US-PS 4 907 748 ist bereits ein Brennstoffeinspritzventil bekannt, das an seinem stromabwärtigen Ende eine aus zwei Siliziumplättchen bestehende Düse aufweist. Ähnlich wie bei den oben beschriebenen Lochscheiben weisen die Ein- und Auslaßöffnungen in den beiden Siliziumplättchen zueinander Versätze auf, so daß ein "S-Schlag" in der Strömung eines durchströmenden Fluids, hier Brennstoff, entsteht.

Alle vorgenannten Lochscheiben aus Silizium besitzen den Nachteil einer eventuell nicht ausreichenden Bruchfestigkeit, die sich durch die Sprödigkeit von Silizium ergibt. Gerade bei Dauerbelastungen z. B. an einem Einspritzventil (Motorschwingungen) besteht die Gefahr, daß die Siliziumplättchen brechen. Die Montage der Siliziumplättchen an metallischen Bauteilen, wie beispielsweise an Einspritzventilen, ist aufwendig, da besondere spannungsfreie Klemmlösungen gefunden werden müssen und die Abdichtung am Ventil problematisch ist. Ein Anschweißen der Lochscheiben aus Silizium am Einspritzventil ist z. B. nicht möglich. Außerdem besteht der Nachteil einer Kantenabnutzung an den Öffnungen der Siliziumscheiben beim oftmaligen Durchströmen mit einem Fluid.

Des weiteren ist bereits aus der DE-PS 483 615 eine Düse für Einspritzbrennkraftmaschinen bekannt, die ebenfalls aus zwei Düsenplättchen gebildet ist, wobei die Düsenplättchen zueinander versetzt angeordnete Ein- und Auslaßöffnungen aufweisen, um ein Zerreißen des durchfließenden Brennstoffs zu begünstigen. Mit dieser Düse ist jedoch in keiner Weise eine Formung des abgespritzten Brennstoffs entsprechend einer gewünschten Geometrie möglich.

Dreischeibige Lochscheiben aus metallischen Plättchen sind aus der EP-A-0 611 886 bekannt.

### Vorteile der Erfindung

Die erfindungsgemäße Lochscheibe mit den kennzeichnenden Merkmalen des Anspruchs 1 hat den Vorteil, daß eine gleichmäßige Feinstzerstäubung eines Fluids ohne Zusatzenergie, also nur über den verfügbaren Mediumdruck, erreicht wird, wobei eine besonders hohe Zerstäubungsgüte und eine an die jeweiligen Erfordernisse angepaßte Strahlformung erzielt wird. Als Konsequenz können bei Verwendung einer solchen Lochscheibe an einem Einspritzventil einer Brennkraftmaschine unter anderem die Abgasemission der Brennkraftmaschine reduziert und ebenso eine Verringerung des Brennstoffverbrauchs erzielt werden.

So können mit den erfindungsgemäßen Lochscheiben in der Form von S-Typ-Scheiben exotische, bizarre Strahlformen erzeugt werden. Diese Lochscheiben ermöglichen für Ein-, Zwei- und Mehrstrahlsprays Strahlquerschnitte in unzähligen Varianten, wie z. B. Rechtecke, Dreiecke, Kreuze, Ellipsen. Solche ungewöhnlichen Strahlformen erlauben eine genaue optimale Anpassung an vorgegebene Geometrien, z. B. an verschiedene Saugrohrquerschnitte von Brennkraftmaschinen. Daraus ergeben sich die Vorteile einer formangepaßten Ausnutzung des verfügbaren Querschnitts zur homogen verteilten, abgasmindernden Gemischeinbringung und einer Vermeidung von abgasschädlichen Wandfilmanlagerungen an der Saugrohrwandung.

Durch die in den Unteransprüchen aufgeführten Maßnahmen sind vorteilhafte Weiterbildungen und Verbesserungen der im Anspruch 1 angegebenen Lochscheibe möglich.

Besonders vorteilhaft ist es, die als Strömungsverbindungen von Ein- und Auslaßöffnungen ausgebildeten Kanäle mit Kanalfortsätzen (cavities) vorzusehen, in denen durch das vorbeiströmende Fluid Strömungswirbel angetrieben werden. Die Wechselwirkung zwischen dem Wirbel und der antreibenden Strömung führt zu zeitlichen Instabilitäten im Wechselwirkungsgebiet. Die Strömung wird zwangsläufig zu Schwingungen angeregt, wodurch zum einen eigenwillige Strahlbilder erzeugbar sind und zum anderen aber auch die resultierende Turbulenz zu einer Reduzierung der mittleren Tröpfchendurchmesser im Spray führt.

Ein weiterer Vorteil ergibt sich durch den Einsatz einer Stolperfalle in der Lochscheibe. Im Nachlauf einer solchen Stolperfalle entsteht eine Wirbelschleppe mit starken Querimpulsen. Die Turbulenz in der Wirbelschleppe trägt dazu bei, daß ein homogenes Spray mit sehr feinen Tröpfchen abgespritzt wird. Die Folge der vorteilhaften Reduzierung des mittleren Tröpfchendurchmessers im Spray ist eine homogene sprayverteilung. Ursache ist die wegen des homogenen Sprays resultierende geringere Tröpfchenverteilungsdichte. Daraus resultiert eine herabgesetzte Wahrscheinlichkeit von Tröpfchenkoagulationen.

Weitere Vorteile sind bei der Beschreibung der Ausführungsbeispiele erwähnt.

Das erfindungsgemäße Verfahren zur Herstellung einer Lochscheibe mit den kennzeichnenden Merkmalen des Anspruchs 15 hat den Vorteil, daß Lochscheiben in reproduzierbarer Weise äußerst präzise und kostengünstig in sehr großen Stückzahlen gleichzeitig herstellbar sind, die aufgrund ihrer metallischen Ausbildung bruchsicher sind und sehr einfach und kostengünstig, beispielsweise durch Schweißen, an metallischen Bauteilen, z. B. Einspritzventilen, montierbar sind. Die erfindungsgemäßen Verfahrensschritte erlauben eine extrem große Gestaltungsfreiheit.

### Zeichnung

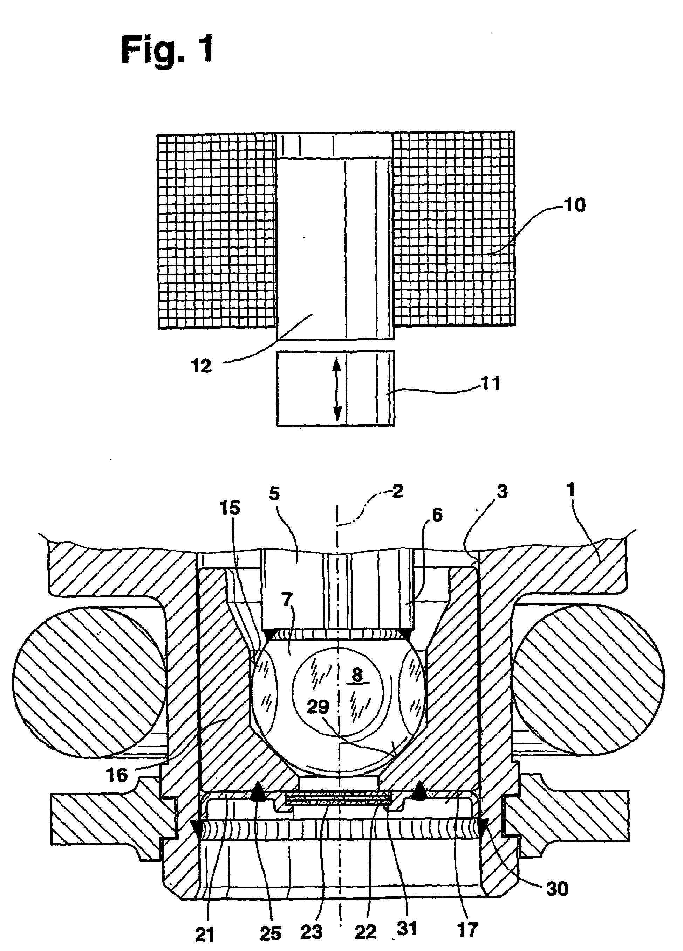

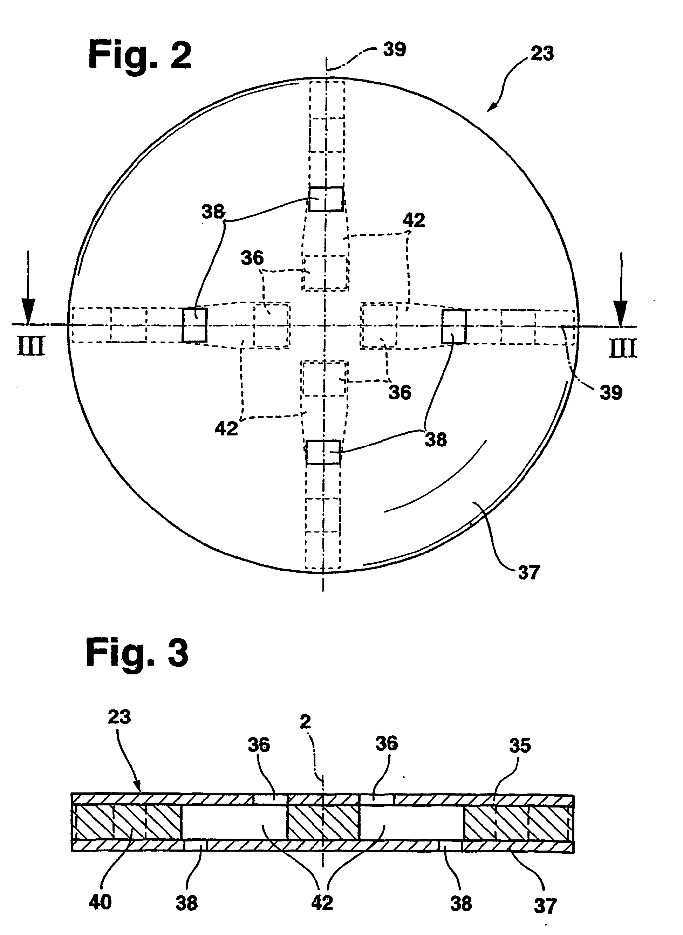

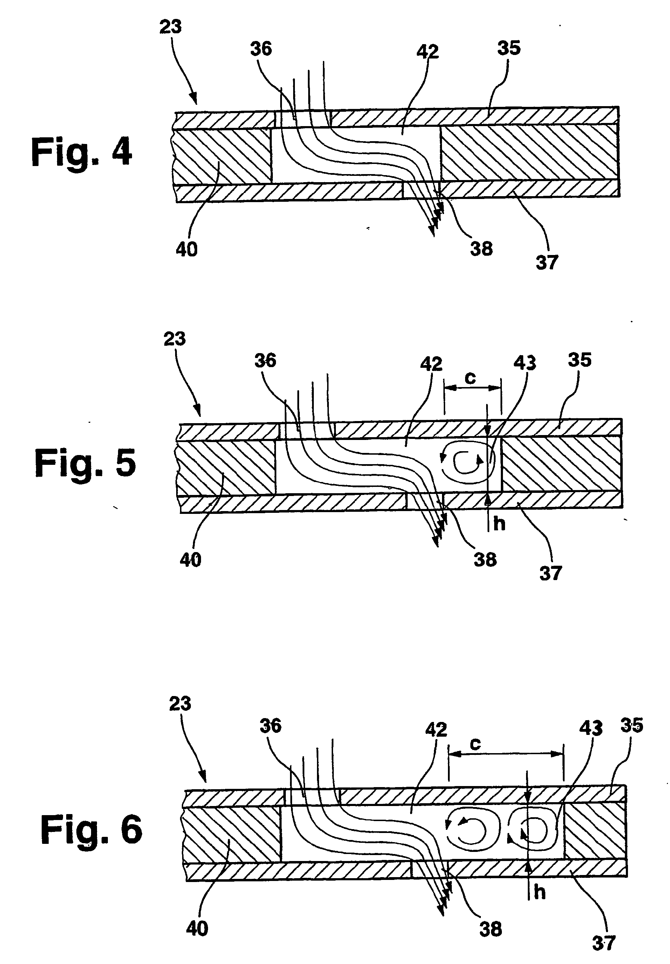

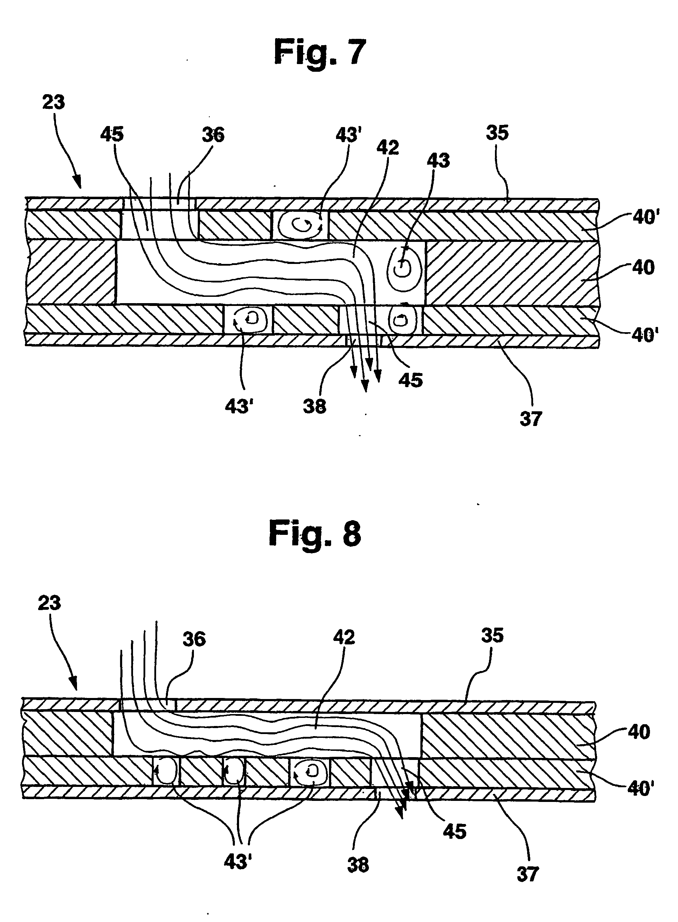

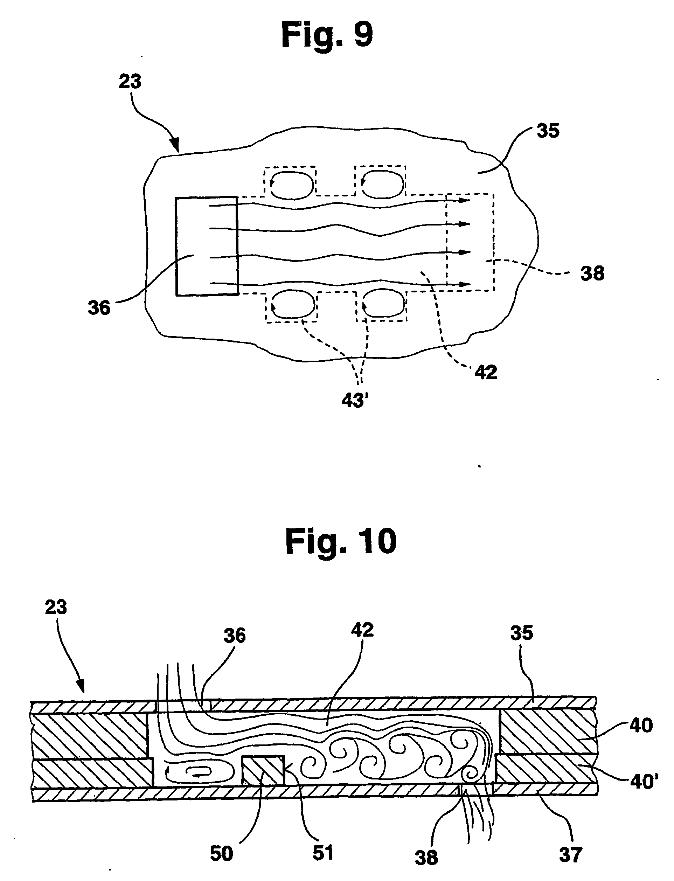

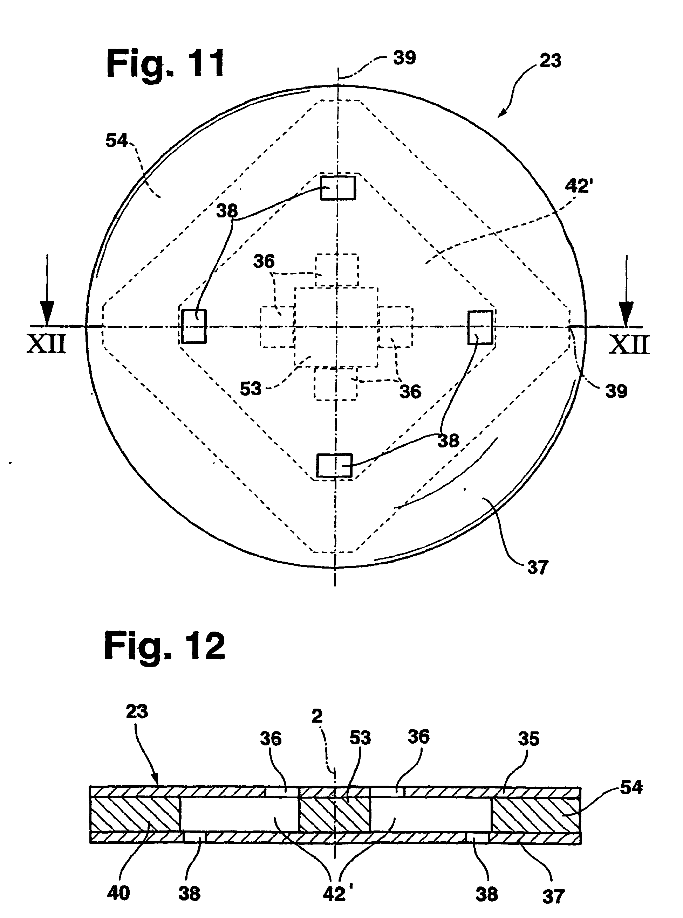

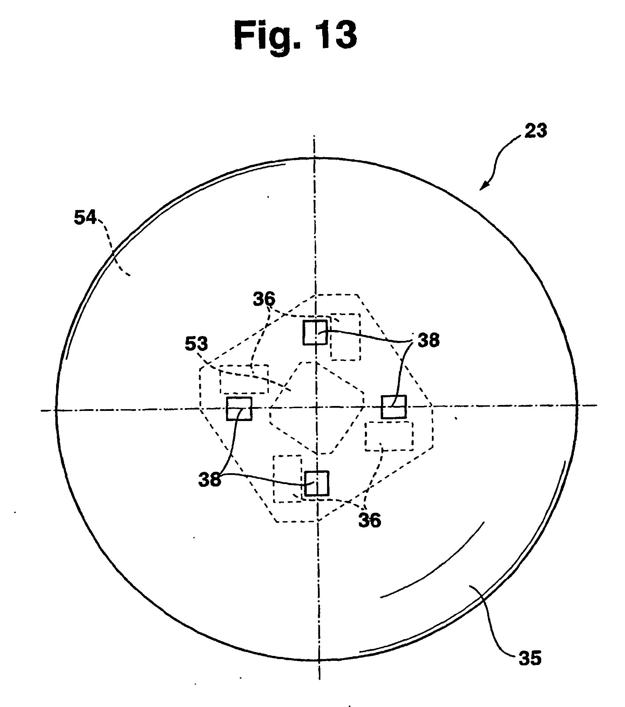

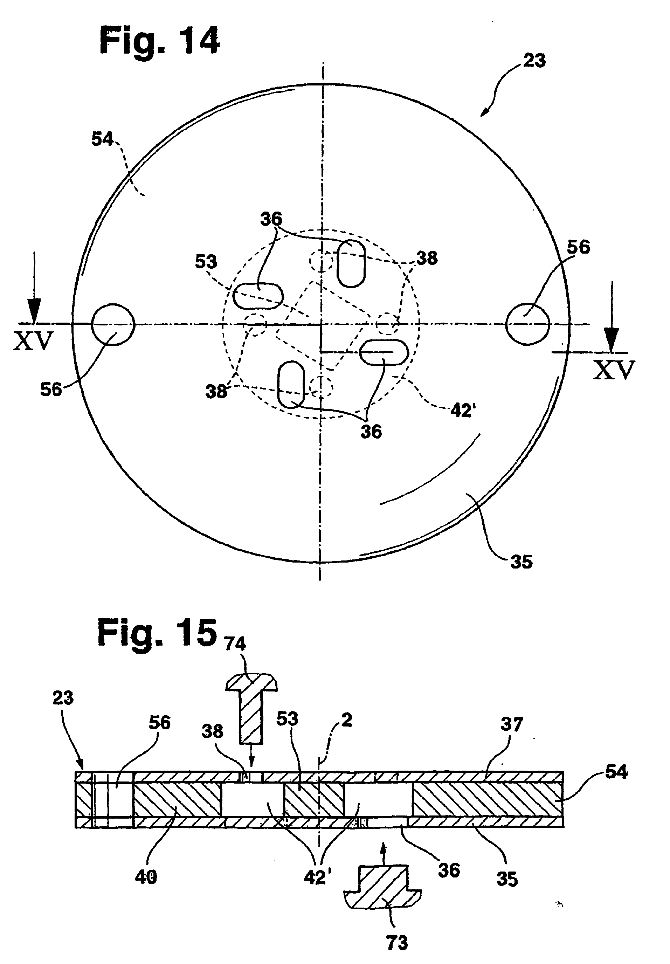

Ausführungsbeispiele der Erfindung sind in der Zeichnung vereinfacht dargestellt und in der nachfolgenden Beschreibung näher erläutert. Es zeigen Figur 1 ein teilweise dargestelltes Einspritzventil mit einer erfindungsgemäßen Lochscheibe, Figur 2 eine Lochscheibe in einer Unteransicht, Figur 3 eine Lochscheibe im Schnitt entlang der Linie III-III in Figur 2, Figur 4 einen Durchströmungsbereich einer dreischichtigen Lochscheibe, Figur 5 einen Durchströmungsbereich einer dreischichtigen Lochscheibe mit einem ersten Kanalfortsatz, Figur 6 einen Durchströmungsbereich einer dreischichtigen Lochscheibe mit einem zweiten Kanalfortsatz, Figur 7 einen Durchströmungsbereich einer fünfschichtigen Lochscheibe mit Kanalfortsätzen, Figur 8 einen Durchströmungsbereich einer vierschichtigen Lochscheibe mit Kanalfortsätzen, Figur 9 eine schematische Draufsicht auf eine Lochscheibe mit seitlichen Kanalfortsätzen, Figur 10 einen Durchströmungsbereich einer Lochscheibe mit Stolperfalle, Figur 11 eine Lochscheibe in einer Unteransicht, Figur 12 eine Lochscheibe im Schnitt entlang der Linie XII-XII in Figur 11, Figur 13 eine Lochscheibe in einer Unteransicht, Figur 14 eine weitere Lochscheibe in einer Draufsicht mit nichteckigen Öffnungen und Figur 15 eine Lochscheibe im Schnitt entlang der Linie XV-XV in Figur 14 mit schematischen Werkzeugen (in umgekehrter Strömungsrichtung).

### Beschreibung der Ausführungsbeispiele

In der Figur 1 ist als ein Ausführungsbeispiel ein Ventil in der Form eines Einspritzventils für Brennstoffeinspritzanlagen von gemischverdichtenden fremdgezündeten Brennkraftmaschinen teilweise dargestellt. Das Einspritzventil hat einen rohrförmigen Ventilsitzträger 1, in dem konzentrisch zu einer Ventillängsachse 2 eine Längsöffnung 3 ausgebildet ist. In der Längsöffnung 3 ist eine z. B. rohrförmige Ventilnadel 5 angeordnet, die an ihrem stromabwärtigen Ende 6 mit einem z. B. kugelförmigen Ventilschließkörper 7, an dessen Umfang beispielsweise fünf Abflachungen 8 vorgesehen sind, verbunden ist.

Die Betätigung des Einspritzventils erfolgt in bekannter Weise, beispielsweise elektromagnetisch. Zur axialen Bewegung der Ventilnadel 5 und damit zum Öffnen entgegen der Federkraft einer nicht dargestellten Rückstellfeder bzw. Schließen des Einspritzventils dient ein angedeuteter elektromagnetischer Kreis mit einer Magnetspule 10, einem Anker 11 und einem Kern 12. Der Anker 11 ist mit dem dem Ventilschließkörper 7 abgewandten Ende der Ventilnadel 5 durch z. B. eine Schweißnaht mittels eines Lasers verbunden und auf den Kern 12 ausgerichtet.

Zur Führung des Ventilschließkörpers 7 während der Axialbewegung dient eine Führungsöffnung 15 eines Ventilsitzkörpers 16. In das stromabwärts liegende, dem Kern 12 abgewandte Ende des Ventilsitzträgers 1 ist in der konzentrisch zur Ventillängsachse 2 verlaufenden Längsöffnung 3 der zylinderförmige Ventilsitzkörper 16 durch Schweißen dicht montiert. An seiner dem Ventilschließkörper 7 abgewandten, unteren Stirnseite 17 ist der Ventilsitzkörper 16 mit einer z.B. topfförmig ausgebildeten Stützscheibe 21 konzentrisch und fest verbunden, die also unmittelbar an dem Ventilsitzkörper 16 anliegt. Die Stützscheibe 21 weist dabei eine ähnliche Form auf wie bereits bekannte topfförmige Spritzlochscheiben, wobei ein mittlerer Bereich der Stützscheibe 21 mit einer gestuften Durchgangsöffnung 22 versehen ist, um in ihr eine erfindungsgemäße Lochscheibe 23 aufzunehmen.

Die Verbindung von Ventilsitzkörper 16 und Stützscheibe 21 erfolgt beispielsweise durch eine umlaufende und dichte, mittels eines Lasers ausgebildete erste Schweißnaht 25. Durch diese Art der Montage ist die Gefahr einer unerwünschten Verformung der Stützscheibe 21 in ihrem mittleren Bereich mit der Durchgangsöffnung 22 und der darin eingebauten Lochscheibe 23 vermieden. Die Stützscheibe 21 ist des weiteren mit der Wandung der Längsöffnung 3 im Ventilsitzträger 1 beispielsweise durch eine umlaufende und dichte zweite Schweißnaht 30 verbunden.

Die Einschubtiefe des aus Ventilsitzkörper 16 und topfförmiger Stützscheibe 21 bestehenden Ventilsitzteils in die Längsöffnung 3 bestimmt die Größe des Hubs der Ventilnadel 5, da die eine Endstellung der Ventilnadel 5 bei nicht erregter Magnetspule 10 durch die Anlage des Ventilschließkörpers 7 an einer Ventilsitzfläche 29 des Ventilsitzkörpers 16 festgelegt ist. Die andere Endstellung der Ventilnadel 5 wird bei erregter Magnetspule 10 beispielsweise durch die Anlage des Ankers 11 an dem Kern 12 festgelegt. Der Weg zwischen diesen beiden Endstellungen der Ventilnadel 5 stellt somit den Hub dar.

Der kugelförmige Ventilschließkörper 7 wirkt mit der sich in Strömungsrichtung kegelstumpfförmig verjüngenden Ventilsitzfläche 29 des Ventilsitzkörpers 16 zusammen, die in axialer Richtung zwischen der Führungsöffnung 15 und der unteren Stirnseite 17 des Ventilsitzkörpers 16 ausgebildet ist.

Die in der Durchgangsöffnung 22 der Stützscheibe 21 angeordnete und durch die Stützscheibe 21 unmittelbar an der Stirnseite 17 des Ventilsitzkörpers 16 festgehaltene Lochscheibe 23 ist in der Figur 1 nur vereinfacht und beispielhaft dargestellt und wird anhand der nachfolgenden Figuren näher beschrieben. Das Einsetzen der Lochscheibe 23 in eine Stützscheibe 21 und eine Klemmung 31 als Befestigung ist eine mögliche Variante des Anbringens der Lochscheibe 23 stromabwärts der Ventilsitzfläche 29. Eine solche Einspannung als indirekte Befestigung der Lochscheibe 23 am Ventilsitzkörper 16 hat den Vorteil, daß temperaturbedingte Verformungen vermieden werden, die eventuell bei Verfahren wie Schweißen oder Löten auftreten könnten. Die Stützscheibe 21 stellt jedoch keineswegs eine ausschließliche Bedingung zur Befestigung der Lochscheibe 23 dar. Da die Befestigungsmöglichkeiten nicht erfindungswesentlich sind, soll hier nur der Verweis auf übliche bekannte Fügeverfahren, wie Schweißen, Löten oder Kleben, erfolgen.

Die Figur 2 zeigt die Lochscheibe 23 in einer Unteransicht. Die Lochscheibe 23 ist als ebene, flache, kreisförmige und mehrschichtige Scheibe ausgeführt, weshalb sie z. B. auch als Multilayer-Spritzlochscheibe bezeichnet werden kann. In der Stützscheibe 21 liegt die Lochscheibe 23 beispielsweise zentriert vor. Durch die Verfahren zur Herstellung der Lochscheibe 23 ergibt sich eine Struktur, die aus mehreren Lagen zusammengesetzt ist. Deutlich wird diese Mehrschichtigkeit der Lochscheibe 23 in der Figur 3, die eine Ansicht entsprechend einem Schnitt entlang der Linie III-III in Figur 2 darstellt.

Bei dem ersten Ausführungsbeispiel bilden drei kreisförmige Schichten z.B. mit gleichem Außendurchmesser die Lochscheibe 23. Eine obere Schicht 35 weist beispielsweise vier rechteckförmige, jeweils in gleichem Abstand zur Ventillängsachse 2 bzw. zur Mittelachse der Lochscheibe 23 ausgebildete und untereinander um 90° versetzte Einlaßöffnungen 36 auf. Die Einlaßöffnungen 36 sind verglichen mit dem Durchmesser der Lochscheibe 23 sehr nahe der Ventillängsachse 2 angeordnet. Mit einem wesentlich größeren Abstand zur Ventillängsachse 2 und damit einem radialen Versatz zu den Einlaßöffnungen 36 sind in einer unteren Schicht 37 ebenfalls vier rechteckförmige Auslaßöffnungen 38 vorgesehen. Die Auslaßöffnungen 38 weisen beispielsweise eine geringfügig kleinere Öffnungsweite als die Einlaßöffnungen 36 auf. Zwei senkrecht zueinander verlaufende, sich an der Ventillängsachse 2 schneidende Achsen 39 der Lochscheibe 23 teilen die Einlaßöffnungen 36 sowie die Auslaßöffnungen 38 jeweils mittig auf, so daß beide Achsen 39 Symmetrieachsen der symmetrisch aufgebauten Lochscheibe 23 darstellen. Entlang der Achsen 39 erstrecken sich ebenfalls in einer mittleren, zwischen der oberen und unteren Schicht 35 und 37 liegenden Schicht 40 radiale Kanäle 42, die eine direkte Verbindung von Einlaßöffnungen 36 und Auslaßöffnungen 38 bilden. Die leicht trapezförmigen Kanäle 42 besitzen z. B. eine solche Größe, daß sie in der Projektion die Einlaßöffnungen 36 und die Auslaßöffnungen 38 gerade überdecken. Alle vier Kanäle 42 liegen bei diesem Ausführungsbeispiel separat voneinander vor. In den Figuren 2 und 3 sind durch Strichlinien weitere mögliche Varianten angedeutet, bei denen die Kanäle 42 verschiedene, deutlich größere radiale Abmessungen besitzen, so daß dann die Kanäle 42 über die Auslaßöffnungen 38 der unteren Schicht 37 radial nach außen deutlich herauslaufen (siehe Figuren 5 und 6).

Bei einem Durchmesser von 4 bis 5 mm besitzt die Lochscheibe 23 z. B. eine Dicke von 0,5 mm, wobei die obere und die untere Schicht 35 und 37 beispielsweise jeweils 0,1 mm und die mittlere Schicht 40 0,3 mm stark sind. Diese Größenangaben zu den Abmessungen der Lochscheibe 23 sowie alle weiteren in der Beschreibung angegebenen Maße dienen nur dem besseren Verständnis und schränken die Erfindung in keiner Weise ein. Auch die relativen Abmaße der einzelnen Strukturen der Lochscheibe 23 in sämtlichen Figuren sind nicht unbedingt maßstäblich.

Aufgrund des bereits angesprochenen radialen Versatzes der Auslaßöffnungen 38 gegenüber den Einlaßöffnungen 36 ergibt sich ein S-förmiger Strömungsverlauf des Mediums, beispielsweise des Brennstoffs. Anhand der Figur 4, die nochmals einen Durchströmungsbereich der Lochscheibe 23 im axialen Schnitt mit der Einlaßöffnung 36, dem Kanal 42 und der Auslaßöffnung 38 hervorhebt, sollen die prinzipiellen Strömungsverhältnisse erläutert werden. Die den Strömungsverlauf kennzeichnenden Pfeile zeigen deutlich die S-Form, weshalb auch bei den erfindungsgemäßen Lochscheiben 23 von S-Typ-Scheiben die Rede ist. Die Lochscheibe 23 wird also von der Einlaßöffnung 36 bis zu der jeweils zugeordneten Auslaßöffnung 38 durchströmt. Von der Einlaßöffnung 36 ausgehend wird die Strömung pro Einlaßöffnung 36 durch den jeweiligen horizontal verlaufenden Kanal 42 radial nach außen geführt. Am Kanalende befindet sich dann bei dem Beispiel nach Figur 4 die Auslaßöffnung 38.

Durch den radial verlaufenden Kanal 42 erhält das Medium eine Radialgeschwindigkeitskomponente. Die Strömung verliert im kurzen axialen Auslaßdurchtritt ihre Radialgeschwindigkeitskomponente nicht völlig. Vielmehr tritt sie mit einseitiger Ablösung an der der Einlaßöffnung 36 zugewandten Wandung der Auslaßöffnung 38 unter einem Winkel zur Ventillängsachse bzw. Mittelachse 2 aus der Lochscheibe 23 aus. Die Kombination mehrerer, z. B. asymmetrisch zueinander ausrichtbarer Einzelstrahlen, die sich durch eine entsprechende Anordnung und Ausrichtung mehrerer Einheiten aus Ein-, Auslaßöffnungen 36 und 38 und Kanälen 42 erzielen lassen, ermöglicht völlig neue, individuelle, komplexe Gesamtstrahlformen mit unterschiedlichen Mengenverteilungen.

Durch den sogenannten S-Schlag innerhalb der Lochscheibe 23 mit mehreren starken Strömungsumlenkungen wird der Strömung eine starke, zerstäubungsfördernde Turbulenz aufgeprägt. Der Geschwindigkeitsgradient quer zur Strömung ist dadurch besonders stark ausgeprägt. Er ist ein Ausdruck für die Änderung der Geschwindigkeit quer zur Strömung, wobei die Geschwindigkeit in der Mitte der Strömung deutlich größer ist als in der Nähe der Wandungen. Die aus den Geschwindigkeitsunterschieden resultierenden erhöhten Scherspannungen im Fluid begünstigen den Zerfall in feine Tröpfchen nahe der Auslaßöffnungen 38. Da die Strömung im Auslaß einseitig abgelöst ist, erfährt sie wegen fehlender Konturführung keine Strömungsberuhigung. Eine besonders hohe Geschwindigkeit weist das Fluid an der abgelösten Seite auf, während die Geschwindigkeit des Fluids zur Seite der Auslaßöffnung 38 mit anliegender Strömung abfällt. Die zerstäubungsfördernden Turbulenzen und Scherspannungen werden somit im Austritt nicht vernichtet.

In den Figuren 5 und 6 sind Ausführungsbeispiele von Lochscheiben 23 dargestellt, bei denen die Kanäle 42 in der mittleren Schicht 40 nicht nur von den Einlaßöffnungen 36 bis hin zu den Auslaßöffnungen 38 verlaufen, sondern über die Auslaßöffnungen 38 hinaus in Richtung der äußeren Begrenzung der Lochscheiben 23. Diese Verlängerungen der Kanäle 42 werden nachfolgend als Kanalfortsätze 43 (cavities) bezeichnet. Zum Prinzip der Strömungsführung und zur Auswirkung auf die Strahlformgebung und Zerstäubung gelten prinzipiell die bereits gemachten Aussagen. Die in die Auslaßöffnung 38 strömende Flüssigkeit streicht weitgehend an dem Kanalfortsatz 43 (cavity) vorbei und treibt in dem Kanalfortsatz 43 einen Strömungswirbel an. Die Wechselwirkung zwischen dem Wirbel und der antreibenden Strömung führt zu zeitlichen Instabilitäten im Wechselwirkungsgebiet. Periodisch verändert der Wirbel seine Größe und drängt beim Anwachsen die vorbeistreichende Strömung ab (entsprechend umgekehrt beim Kleinerwerden des Wirbels). Die austretende Strömung wird somit periodisch in der Richtungsgebung abgelenkt und damit zu Schwingungen angeregt. Frequenz und Amplitude der Oszillationen in der Austrittsströmung hängen dabei von der Gestaltung des Kanalfortsatzes 43 ab, und zwar von der radialen Tiefe c und der Höhe h, die sich durch die Dicke der mittleren Schicht 40 ergibt. In dem in der Figur 5 gezeigten Ausführungsbeispiel gilt z. B. c = h, während bei dem Beispiel in Figur 6 für die Größe des Kanalfortsatzes 43 c = 2 x h gilt. Die Geometrie des in der Figur 6 gezeigten Kanalfortsatzes 43 führt dazu, daß ein Doppelwirbel entsteht, wobei sich beide Wirbel durch Impulsaüstausch antreiben und eine gegensinnige Wirbelrichtung aufweisen.

Durch die Oszillationen in den einzelnen Austrittsstrahlen ergeben sich sowohl in den Einzelstrahlen als auch im Gesamtspray Schwingungsmuster. Durch diese Schwingungsmuster sind die unterschiedlichsten bizarren Strahlquerschnitte erreichbar (z. B. Rechteck, Dreieck, Kreuz, Kreis). Ohne solche Strahlschwingungen wären diese Querschnittsformen nicht erzielbar; sonst besteht die Tendenz zu kreisförmigen Querschnitten der Einzelstrahlen. Die beliebigen Muster bzw. Querschnitte der Einzelstrahlen bzw. des Gesamtsprays als Summe aller Einzelstrahlen, die sich durch Impulsaustausch in ständiger Wechselwirkung miteinander befinden, sind also besonders dann erreichbar, wenn die Oszillationen im Fluid hochfrequent sind. Zudem wird durch die Richtungsänderungen das Spray gleichmäßiger über den Strahlquerschnitt verteilt. Dadurch wird das Spray homogener und durchmischt sich so besser mit der Saugrohrluftströmung zur Bildung eines abgasreduzierenden Gemisches.

Die durch die Turbulenz vorhandenen Querimpulse quer zur Strömung- führen unter anderem dazu, daß die Tröpfchenverteilungsdichte im abgespritzten Spray eine große Gleichmäßigkeit aufweist. Daraus resultiert eine herabgesetzte Wahrscheinlichkeit von Tröpfchenkoagulationen, also von Vereinigungen kleiner Tröpfchen zu größeren Tropfen. Die Folge der vorteilhaften Reduzierung des mittleren Tröpfchendurchmessers im Spray ist eine relativ homogene Sprayverteilung. Durch den S-Schlag wird in dem Fluid eine feinskalige (hochfrequente) Turbulenz erzeugt, welche den Strahl unmittelbar nach Austritt aus der Lochscheibe 23 in entsprechend feine Tröpfchen zerfallen läßt. Je größer die sich aus der Turbulenz ergebenden Scherspannungen sind, desto größer ist auch die Streuung der Strömungsvektoren. Die Scherspannungen sorgen dafür, daß ein "chaotischer Zustand" in allen Ebenen des Fluids herrscht, so daß eine gewünschte Spreizung der Strahlen bzw. des Sprays auftritt, die zu den bereits angesprochenen unterschiedlichen Querschnitten bzw. Mustern führen kann.

In den Figuren 7, 8 und 9 sind einige leicht abgewandelte Ausführungsbeispiele dargestellt, die sich vor allen Dingen von den vorhergehenden Ausführungsbeispielen dadurch unterscheiden, daß sie mehr als drei Schichten aufweisen und Kanalfortsätze 43' nicht nur in radialer Richtung als Verlängerung des Kanals 42 besitzen. In der Figur 7 ist eine fünfschichtige Lochscheibe 23 gezeigt, in der neben den bekannten drei Schichten 35, 37 und 40 noch zwei weitere mittlere Schichten 40' ausgebildet sind. Diese zwei zusätzlichen Schichten 40' liegen jeweils zwischen der mittleren Schicht 40 und der oberen bzw. unteren Schicht 35 bzw. 37. Um ein Durchströmen des Fluids durch die Lochscheibe 23 von der Einlaßöffnung 36 bis zur Auslaßöffnung 38 zu gewährleisten, besitzen die beiden Schichten 40' auch entsprechende Öffnungsbereiche 45, die die Verbindung zum in der Schicht 40 vorgesehenen Kanal 42 herstellen. Neben diesen Öffnungsbereichen 45 ist in den Schichten 40' noch jeweils wenigstens ein Kanalfortsatz 43' eingebracht, der z. B. die axiale Höhe der Schicht 40' hat. In radialer Richtung gesehen liegen die Kanalfortsätze 43' beispielsweise zwischen der Einlaßöffnung 36 und der Auslaßöffnung 38. Die Strömung des Fluids treibt nun wieder Strömungswirbel in den Kanalfortsätzen 43' an. Zusätzlich zu den axial versetzt zum Kanal 42 liegenden Kanalfortsätzen 43' können auch radial an den Kanal 42 anschließende Kanalfortsätze 43 vorgesehen sein.

Die Figur 8 zeigt eine Variante einer Lochscheibe 23 mit vier Schichten, also nur mit einer zusätzlichen mittleren Schicht 40'. Je nach Anordnung der Schicht 40' oberhalb oder unterhalb der Schicht 40 muß die Schicht 40' wiederum einen Öffnungsbereich 45 aufweisen, hier in der Figur 8 einen unmittelbar an der Auslaßöffnung 38 eingebrachten Öffnungsbereich 45. In der Schicht 40' befinden sich zusätzlich Kanalfortsätze 43', die axial zum Kanal 42 versetzte Kammern darstellen, in denen Strömungswirbel entstehen. Die z. B. drei Kanalfortsätze 43' in der Schicht 40' können im gleichen Abstand zueinander oder auch willkürlich aufgeteilt sein. Eine schematische Draufsicht auf einen Teil einer Lochscheibe 23 zeigt die Figur 9. Dabei wird deutlich, daß die Kanalfortsätze 43' nicht nur in axialer Richtung der Lochscheibe 23, also in die Tiefe, eingebracht sein können, sondern durchaus über die Breite des Kanals 42 hinausragend ausgebildet sein können. Somit sind Kanalfortsätze 43, 43' in allen drei Richtungen, also in Länge, Breite und Tiefe, am Kanal 42 ausformbar.

Alle vorangegangenen Beispiele können mit dem Merkmal einer Grenzschichtstolperfalle, wie sie die Figur 10 zeigt, ausgestattet werden. Die Lochscheibe 23 ist in diesem konkreten Fall vierschichtig ausgebildet. Zwischen den beiden oberen und unteren Schichten 35 und 37 befinden sich nun z. B. zwei mittlere Schichten 40 und 40'. Die zusätzliche mittlere Schicht 40', die unmittelbar auf der unteren Schicht 37 folgt, ist derart ausgebildet, daß sich quer zur Strömungsrichtung im Bereich des Kanals 42 eine z. B. quaderförmige, scharfkantige Erhebung, nämlich eine Stolperfalle 50 erstreckt. Denkbar ist natürlich auch die Anordnung einer Stolperfalle 50 in der mittleren Schicht 40, so daß dann die Stolperfalle 50 von oben in den Kanal 42 hineinragen würde. Von der Geometrie her sollte die Stolperfalle 50 mit radialem Versatz zur Einlaßöffnung 36 ausgeformt sein. Der Kanal 42 erstreckt sich zwischen den Schichten 35 und 37 sowohl in der Schicht 40 als auch in der Schicht 40'.

Die Hauptströmung des Fluids streicht über die Grenzschichtstolperfalle 50. An einer hinteren, stromabwärtigen Stolperkante 51 löst sich die Strömung von der Stolperfalle 50 ab und erfährt wegen der plötzlichen Querschnittserweiterung stromab der Stolperfalle 50 einen Druckanstieg (Umwandlung von kinetischer Energie in Druckenergie - Diffusorwirkung). Dieser Druckanstieg führt zu intensiven Grenzschichtverwirbelungen im Nachlauf der Stolperfalle 50.

Es entsteht im Nachlauf der Stolperfalle 50 eine stets größerwerdende Wirbelschleppe mit starken Querimpulsen, welche bis zur Auslaßöffnung 38 reicht. Die Wirbelschleppe zieht sich durch die Hauptströmung als "Turbulenzstrang" durch. Die Turbulenz in der Wirbelschleppe kann sehr feinskalig (hochfrequent) sein und eine große Amplitude aufweisen. Die Frequenz- und Amplitudenabstimmung erfolgt über die Höhe der Stolperfalle 50 und die Geschwindigkeit der vorbeistreichenden Hauptströmung, d. h. über die Kanalquerschnittsfläche oberhalb der Stolperfalle 50.

Die Wirbelschleppe kann Durchströmverluste reduzieren, da in ihr ein hoher turbulenter Impulsaustausch quer zur Hauptströmung in Richtung der Wandungen stattfindet. Daraus ergibt sich, daß die Hauptströmung im Nachlauf der Stolperfalle 50 weniger zum Ablösen von den Wandungen des Kanals 42 neigt und dadurch die zur Verfügung stehenden Durchströmquerschnitte besser nutzt. Eine Ablösung der Strömung von der Wandung würde zu einem Druckverlust führen. Auch die Stolperfalle 50 dient dazu, ein homogenes Spray abzuspritzen, das in sehr feine Tröpfchen zerfällt, wobei wiederum die unterschiedlichsten Abspritzmuster erzielbar sind.

In den vorangegangenen Beispielen besaß ein jedes Einlaß-/Auslaßöffnungspaar 36, 38 einen separaten Kanal 42 als Verbindung dieser Öffnungen 36, 38. Im Gegensatz dazu ist in den Figuren 11 und 12 ein Ausführungsbeispiel dargestellt, das nur einen einzigen zusammenhängenden Kanal 42' in der Lochscheibe 23 aufweist. Alle vier Einlaßöffnungen 36 münden in diesen z. B. quadratförmigen Kanal 42', und alle vier Auslaßöffnungen 38 führen auch wieder aus dem Kanal 42' heraus. Bei Verwendung rechteckiger oder quadratischer Auslaßöffnungen 38 bietet es sich an, die Außenkontur des Kanals 42' in der mittleren Schicht achteckig, durch die Nähe jeweils zweier Ecken jedoch fast quadratisch auszubilden, so wie es die Figur 11 zeigt. Nach innen ist der Kanal 42' durch eine z. B. quadratische Materialinsel 53 der mittleren Schicht 40 begrenzt. Diese innere Materialinsel 53 hat ungefähr eine solche Größe im Querschnitt, wie der sich zwischen den Einlaßöffnungen 36 ergebende Bereich in der oberen Schicht 35. Die Schicht 40 besteht also aus zwei Abschnitten, nämlich aus der von dem Kanal 42' vollständig umgebenen Materialinsel 53 und einem wiederum den Kanal 42' vollständig umgebenden Außenbereich 54. Die Figur 12 ist eine Ansicht der Lochscheibe 23 entsprechend einem Schnitt entlang der Linie XII-XII in Figur 11.

Durch das zusätzlich entstandene Verbindungsvolumen gibt es zunehmend sogenannte Totwassergebiete, an denen die Hauptströmung vorbeistreicht. In den Totwassergebieten entsteht die Schwingungsanregung der Hauptströmung nach dem Cavityprinzip mit den Kanalfortsätzen 43, 43'. Entsprechend ist die Auswirkung auf die Strahlformgebung und die Zerstäubung identisch wie bei den vorangegangenen Beispielen mit den Kanalfortsätzen 43, 43' (Cavities).

Der Versatz der Auslaßöffnungen 38 zu den Einlaßöffnungen 36 muß keineswegs radial verlaufen, wie es in den vorhergehenden Beispielen der Fall war, sondern kann in beliebige gewünschte Richtungen vorgesehen sein. Zwei Ausführungsbeispiele für einen solchen anderen Versatz zeigen die Figuren 13 und 14 als Unteransicht bzw. Draufsicht auf jeweils eine Lochscheibe 23. Hierbei wird deutlich, daß die Auslaßöffnungen 38 eher in Umfangsrichtung zu den Einlaßöffnungen 36 versetzt sind, also z. B. um 90° gedreht gegenüber den Beispielen mit radialem Versatz. Der Kanal 42' in der mittleren Schicht 40 der Lochscheibe 23 in Figur 13 besitzt z. B. eine achteckige, jedoch weitgehend quadratische Außenkontur, wobei die Ecken der Wandung des Kanals 42' immer nahe der Einlaß- und Auslaßöffnungen 36 und 38 liegen. Die Materialinsel 53 der mittleren Schicht 40 begrenzt den Kanal 42' nach innen mit einer ebenfalls fast quadratischen, allerdings acht Ecken aufweisenden Kontur. Die äußere und die innere Begrenzungswand des Kanals 42' sind beispielsweise um 45° zueinander verdreht ausgebildet. Damit weisen der Außenbereich 54 und die Materialinsel 53 keine parallel verlaufenden Wandungen auf.

Die in den Figuren 14 und 15 (Schnitt entlang der Linie XV-XV in Figur 14) gezeigte Lochscheibe 23 zeichnet sich besonders durch ihre nichteckigen Einlaß- und Auslaßöffnungen 36 und 38 aus. Die Einlaßöffnungen 36 in der oberen Schicht 35 besitzen z.B. einen elliptischen Querschnitt, während die Auslaßöffnungen 38 in der unteren Scheibe 37 kreisförmig ausgebildet sind. Die innere Materialinsel 53 weist beispielsweise einen quadratischen Querschnitt auf, während der Kanal 42' in der mittleren Schicht 40 nach außen hin vom Außenbereich 54 kreisförmig begrenzt wird. Zum besseren Handling der Lochscheiben 23 bei der Anwendung der verschiedenen Herstellungsverfahren sind z.B. zwei Positionieraufnahmen 56 in Form von Durchgangslöchern nahe der äußeren Begrenzung vorgesehen.

Die Einlaßöffnungen 36 und die Auslaßöffnungen 38 können mit beliebig großem Versatz zueinander angeordnet sein. Bei den Ausführungsbeispielen in den Figuren 13 und 14 liegen beispielsweise wesentlich geringere Versätze vor als bei allen anderen zuvor gezeigten Beispielen. Über die Größe des Versatzes können die Strahlrichtung und der Turbulenzgrad abgestimmt bzw. eingestellt werden.

Die bis Figur 13 gezeigten Einlaßöffnungen 36, Auslaßöffnungen 38 sowie Kanäle 42, 42' besitzen stets quadratische bzw. rechteckförmige Querschnitte. Die erfindungsgemäßen Verfahren erlauben es jedoch, auch völlig andere Querschnitte der durchströmten Geometrien der Lochscheibe 23 zu erzeugen (siehe Figur 14). Die Wandungen der einzelnen Strukturen verlaufen dabei weitgehend parallel zur Ventillängsachse 2. Interessant kann auch die unterschiedliche Ausbildung von Einlaßöffnungen 36 und Auslaßöffnungen 38 sein, die über einen Kanal 42, 42' direkt miteinander verbunden sind. Geeignete Querschnittsveränderungen stellen z. B. die Übergänge von Quadrat zu Rechteck und umgekehrt, von Rechteck zu Kreis und umgekehrt, von Ellipse zu Kreis und umgekehrt dar.

Alle beschriebenen Lochscheiben 23 sind nicht ausschließlich für den Gebrauch an Einspritzventilen vorgesehen; sie können vielmehr auch z. B. bei Lackierdüsen, bei Inhalatoren, bei Tintenstrahldruckern oder bei Gefriertrockenverfahren zum Einsatz kommen. Zur Erzeugung feiner Sprays, z. B. mit großen Winkeln, eignen sich die Lochscheiben 23 ganz allgemein. Zur Herstellung von die oben beschriebene Kontur aufweisenden S-Typ-Scheiben als Lochscheiben 23 sind Verfahren wie Senkerodieren, Drahterodieren, Laserschneiden oder Stanzen denkbar.

In der Figur 15 sind deshalb schematisch einige Werkzeuge dargestellt, die diese Fertigungsverfahren verdeutlichen sollen. Mit den Positionieraufnahmen 56 ist beim Fügen der einzelnen Metallscheiben eine exakte Positionierung untereinander möglich. Die einzelnen Schichten der Lochscheibe 23 werden jedoch vor dem Fügen getrennt voneinander bearbeitet, beim Stanzen z.B. mit Stanzstempeln 73 bzw. beim Erodieren mit Werkzeugelektroden 74.

## Patentansprüche

1. Lochscheibe (23), insbesondere für Einspritzventile, mit einem vollständigen Durchgang für ein Fluid, mit wenigstens einer Einlass- (36) und wenigstens einer Auslassöffnung (38), wobei jede Einlassöffnung (36) in einer oberen Scheibe (35) der Lochscheibe (23) und jede Auslassöffnung (38) in einer unteren Scheibe (37) der Lochscheibe (23) eingebracht ist, und mit wenigstens einer weiteren mittleren Scheibe (40, 40') zwischen der oberen Scheibe (35) und der unteren Scheibe (37), die wenigstens einen Kanal (42, 42') aufweist, der eine vollständige Verbindung von wenigstens einer der Einlassöffnungen (36) mit wenigstens einer der Auslassöffnungen (38) darstellt, **dadurch gekennzeichnet, dass** die obere Scheibe (35) eine Mehrzahl von Einlassöffnungen (36) und die untere Scheibe (37) eine Mehrzahl von Auslassöffnungen (38) aufweist, wobei sich die Einlass- (36) und die Auslassöffnungen (38) bei einer Projektion in eine Ebene an keiner Stelle überdecken und die Einlassöffnungen (36) näher zu einer Mittelachse (2) der Lochscheibe (23) ausgebildet sind als die Auslassöffnungen (38), so dass ein radialer Versatz in Strömungsrichtung nach außen vorhanden ist und die Einlassöffnungen (36), die Auslassöffnungen (38) und die Kanäle (42, 42') mittels Senkerodieren, Drahterodieren, Laserschneiden oder Stanzen hergestellt sind.

2. Lochscheibe nach Anspruch 1, **dadurch gekennzeichnet, dass** in wenigstens einer mittleren Scheibe (40) eine der Anzahl der Einlassöffnungen (36) und der Auslassöffnungen (38) entsprechende Zahl an Kanälen (42) vorgesehen ist, so dass genau eine Einlassöffnung (36) über einen Kanal (42) mit einer Auslassöffnung (38) verbunden ist.

3. Lochscheibe nach Anspruch 1, **dadurch gekennzeichnet, dass** in wenigstens einer mittleren Scheibe (40) ein Kanal (42') vorgesehen ist, mit dem alle Einlassöffnungen (36) und alle Auslassöffnungen (38) in Verbindung stehen.

4. Lochscheibe nach einem der vorhergehenden Ansprüche, **dadurch gekennzeichnet, dass** wenigstens eine der Einlassöffnungen (36) eine andere Öffnungsweite als eine der Auslassöffnungen (38) besitzt.

5. Lochscheibe nach einem der vorhergehenden Ansprüche, **dadurch gekennzeichnet, dass** die Einlassöffnungen (36) und die Auslassöffnungen (38) vollständig symmetrisch um eine Mittelachse (2) der Lochscheibe (23) angeordnet sind.

6. Lochscheibe nach einem der vorhergehenden Ansprüche, **dadurch gekennzeichnet, dass** die Kanäle (42,42') jeweils eine solche Größe haben, dass sie in der Projektion die Einlassöffnungen (36) und die Auslassöffnungen (38) vollständig überdecken.

7. Lochscheibe nach einem der vorhergehenden Ansprüche, **dadurch gekennzeichnet, dass** der wenigstens eine Kanal (42, 42') wenigstens einen Kanalfortsatz (43, 43') besitzt, der ein Gebiet darstellt, das sich nicht auf dem kürzesten Strömungsweg von den Einlassöffnungen (36) zu den Auslassöfmungen (38) befindet.

8. Lochscheibe nach Anspruch 7, **dadurch gekennzeichnet, dass** der wenigstens eine Kanalfortsatz (43) die gleiche Höhe wie der Kanal (42) aufweist.

9. Lochscheibe nach Anspruch 7, **dadurch gekennzeichnet, dass** der wenigstens eine Kanalfortsatz (43) in seiner Höhe und Breite das gleiche Abmaß besitzt.

10. Lochscheibe nach Anspruch 1, **dadurch gekennzeichnet, dass** die Lochscheibe (23) vierscheibig ausgebildet ist, wobei in der einen mittleren Scheibe (40) der wenigstens eine Kanal (42,42') verläuft und in der anderen mittleren Scheibe (40') Kanalfortsätze (43') vorgesehen sind, die Gebiete darstellen, die sich nicht auf dem kürzesten Strömungsweg von den Einlassöffnungen (36) zu den Auslassöffnungen (38) befinden.

11. Lochscheibe nach Anspruch 1, **dadurch gekennzeichnet, dass** die Lochscheibe (23) fünfscheibig ausgebildet ist, wobei in einer der mittleren Scheiben (40) der wenigstens eine Kanal (42, 42') verläuft und in den anderen beiden mittleren Scheiben (40') Kanalfortsätze (43') vorgesehen sind, die Gebiete darstellen, die sich nicht auf dem kürzesten Strömungsweg von den Einlassöffnungen (36) zu den Auslassöffnungen (38) befinden.

12. Lochscheibe nach einem der vorhergehenden Ansprüche, **dadurch gekennzeichnet, dass** zumindest in eine mittlere Scheibe (40, 40') hineinragend wenigstens eine Stolperfalle (50) angeordnet ist, durch die eine im Kanal (42, 42') vorbei streichende Strömung eine Wirbelschleppe bildet.

13. Verfahren zur Herstellung einer Lochscheibe (23), insbesondere einer Lochscheibe für Einspritzventile, die einen vollständigen Durchgang für ein Fluid, wenigstens eine Einlass- (36) und wenigstens eine Auslmöffnung (38) aufweist, wobei jede Einlassöffnung (36) in einer oberen Scheibe (35) der Lochscheibe (23) und jede Auslassöffnung (38) in einer unteren Scheibe (37) der Lochscheibe (23) eingebracht wird, und wenigstens eine weitere mittlere Scheibe (40,40') zwischen der oberen Scheibe (35) und der unteren Scheibe (37) eingebracht wird, die wenigstens einen Kanal (42,42') aufweist, der eine vollständige Verbindung von wenigstens einer der Einlassöffnungen (36) mit wenigstens einer der Auslassöffnungen (38) darstellt, **dadurch gekennzeichnet, dass** die obere Scheibe (35) mit einer Mehrzahl von Einlassöffnungen (36) und die untere Scheibe (37) mit einer Mehrzahl von Auslassöffnungen (38) ausgebildet wird, wobei die Einlass (36) und die Auslassöffinungen (38) derart angeordnet werden, dass sie sich bei einer Projektion in eine Ebene an keiner Stelle überdecken und die Einlassöffnungen (36) näher zu einer Mittelachse (2) der Lochscheibe (23) ausgebildet werden als die Auslassöffnungen (38), so dass ein radialer Versatz in Strömungsrichtung nach außen entsteht und die Einlassöffnungen (36), die Auslassöffnungen (38) und die Kanäle (42, 42') mittels Senkerodieren, Drahterodieren, Laserschneiden oder Stanzen ausgeformt werden.

## Claims

1. Perforated disc (23), especially for injection valves, having a full passageway for a fluid, having at least one inlet opening (36) and at least one outlet opening (38), each inlet opening (36) being provided in an upper disc (35) of the perforated disc (23) and each outlet opening (38) being provided in a lower disc (37) of the perforated disc (23), and having at least one further, central disc (40, 40') between the upper disc (35) and the lower disc (37), which central disc (40, 40') has at least one passage (42, 42') which constitutes a full connection of at least one of the inlet openings (36) to at least one of the outlet openings (38), **characterized in that** the upper disc (35) has a plurality of inlet openings (36) and the lower disc (37) has a plurality of outlet openings (38), the inlet openings (36) and the outlet openings (38) not overlapping at any point in a projection into a plane, and the inlet openings (36) being formed closer to a central axis (2) of the perforated disc (23) than the outlet openings (38), so that there is a radial offset outwards in the direction of flow, and the inlet openings (36), the outlet openings (38) and the passages (42, 42') being produced by means of electric discharge machining, electric discharge wire cutting, laser cutting or punching.

2. Perforated disc according to Claim 1, **characterized in that** a number of passages (42) corresponding to the number of inlet openings (36) and outlet openings (38) is provided in at least one central disc (40), so that just one inlet opening (36) is connected via a passage (42) to an outlet opening (38).

3. Perforated disc according to Claim 1, **characterized in that** a passage (42') to which all of the inlet openings (36) and all of the outlet openings (38) are connected is provided in at least one central disc (40).

4. Perforated disc according to one of the preceding claims, **characterized in that** at least one of the inlet openings (36) has a different opening width from one of the outlet openings (38).

5. Perforated disc according to one of the preceding claims, **characterized in that** the inlet openings (36) and the outlet openings (38) are arranged completely symmetrically around a central axis (2) of the perforated disc (23).

6. Perforated disc according to one of the preceding claims, **characterized in that** the passages (42, 42') are in each case of such a size that, in projection, they fully overlap the inlet openings (36) and the outlet openings (38).

7. Perforated disc according to one of the preceding claims, **characterized in that** the at least one passage (42, 42') has at least one passage extension (43, 43') constituting an area which is not located on the shortest flow path from the inlet openings (36) to the outlet openings (38).

8. Perforated disc according to Claim 7, **characterized in that** the at least one passage extension (43) is the same height as the passage (42).

9. Perforated disc according to Claim 7, **characterized in that** the at least one passage extension (43) is the same size in its height and width.

10. Perforated disc according to Claim 1, **characterized in that** the perforated disc (23) is designed with four discs, the at least one passage (42, 42') running in one central disc (40) and in the other central disc (40') there being passage extensions (43) constituting areas which are not situated on the shortest flow path from the inlet openings (36) to the outlet openings (38).

11. Perforated disc according to Claim 1, **characterized in that** the perforated disc (23) is designed with five discs, the at least one passage (42, 42') running in one of the central discs (40) and in the other two central discs (40') there being passage extensions (43) constituting areas which are not situated on the shortest flow path from the inlet openings (36) to the outlet openings (38).

12. Perforated disc according to one of the preceding claims, **characterized in that** at least one turbulence trap (50) is arranged in a manner protruding at least into a central disc (40, 40'), by means of which turbulence trap (50) a flow brushing past in the passage (42, 42') forms a vortex trail.

13. Process for producing a perforated disc (23), especially a perforated disc for injection valves, which has a full passageway for a fluid, and at least one inlet opening (36) and at least one outlet opening (38), each inlet opening (36) being provided in an upper disc (35) of the perforated disc (23) and each outlet opening (38) being provided in a lower disc (37) of the perforated disc (23), and at least one further, central disc (40, 40') being provided between the upper disc (35) and the lower disc (37), which central disc (40, 40') has at least one passage (42, 42') which constitutes a full connection of at least one of the inlet openings (36) to at least one of the outlet openings (38), **characterized in that** the upper disc (35) is designed with a plurality of inlet openings (36) and the lower disc (37) is designed with a plurality of outlet openings (38), the inlet openings (36) and the outlet openings (38) being arranged in such a manner that they do not overlap at any point in a projection into a plane, and the inlet openings (36) being formed closer to a central axis (2) of the perforated disc (23) than the outlet openings (38), so that there is a radial offset outwards in the flow direction, and the inlet openings (36), the outlet openings (38) and the passages (42, 42') being formed by means of electric discharge machining, electric discharge wire cutting, laser cutting or punching.

## Revendications

1. Disque perforé (23), en particulier pour injecteurs, comportant un passage complètement débouchant pour un fluide, au moins une ouverture d'entrée (36) et au moins une ouverture de sortie (38), chaque ouverture d'entrée (36) étant formée dans un disque supérieur (35) du disque perforé (23) et chaque ouverture de sortie (38) étant formée dans un disque inférieur (37) du disque perforé (23), et au moins un disque central additionnel (40, 40') interposé entre le disque supérieur (35) et le disque inférieur (37) et qui présente au moins un canal (42, 42') représentant une liaison complète entre au moins une des ouvertures d'entrée (36) et au moins une des ouvertures de sortie (38),
**caractérisé en ce que**
le disque supérieur (35) présente une pluralité d'ouvertures d'entrée (36) et le disque inférieur (37) présente une pluralité d'ouvertures de sortie (38), les ouvertures d'entrée (36) et les ouvertures de sortie (38) ne se recouvrant en aucun endroit dans une projection sur un plan et les ouvertures d'entrée (36) étant formées plus près d'un axe médian (2) du disque perforé (23) que les ouvertures de sortie (38), de sorte qu'il existe un décalage radial vers l'extérieur dans le sens de l'écoulement et que les ouvertures d'entrée (36), les ouvertures de sortie (38) et les canaux (42, 42') sont produits par érosion profonde, érosion au fil, coupe au laser ou découpage à la presse.

2. Disque perforé selon la revendication 1,
**caractérisé en ce qu'**
il est prévu dans au moins un disque central (40) un nombre de canaux (42) correspondant au nombre des ouvertures d'entrée (36) et des ouvertures de sortie (38), de sorte qu'une ouverture d'entrée (36) peut être reliée précisément à une ouverture de sortie (38) par l'intermédiaire d'un canal (42).

3. Disque perforé selon la revendication 1,
**caractérisé en ce que**
dans au moins un disque central (40) est prévu un canal (42') avec lequel toutes les ouvertures d'entrée (36) sont en communication avec toutes les ouvertures de sortie (38).

4. Disque perforé selon une des revendications précédentes,
**caractérisé en ce qu'**
au moins une des ouvertures d'entrée (36) possède une dimension d'ouverture différente de celle des ouvertures de sortie (38).

5. Disque perforé selon une des revendications précédentes,
**caractérisé en ce que**
les ouvertures d'entrée (36) et les ouvertures de sortie (38) sont disposées de façon entièrement symétrique par rapport à un axe médian (2) du disque perforé (23).

6. Disque perforé selon une des revendications précédentes,
**caractérisé en ce que**
les canaux (42, 42') ont chacun une dimension telle qu'en projection, ils recouvrent entièrement les ouvertures d'entrée (36) et les ouvertures de sortie (38).

7. Disque perforé selon une des revendications précédentes,
**caractérisé en ce que**
l'au moins un canal (42, 42') possède un prolongement de canal (43, 43') qui représente une zone ne se trouvant pas sur le trajet d'écoulement le plus court allant des ouvertures d'entrée (36) aux ouvertures de sortie (38).

8. Disque perforé selon la revendication 7,
**caractérisé en ce que**
l'au moins un prolongement de canal (43) présente la même hauteur que le canal (42).

9. Disque perforé selon la revendication 7,
**caractérisé en ce que**
l'au moins un prolongement de canal (43) possède la même dimension en hauteur et en largeur.

10. Disque perforé selon la revendication 1,
**caractérisé en ce que**
le disque perforé (23) est formé de quatre disques, l'au moins un canal (42, 42') s'étendant dans un des disques centraux (40), tandis que, dans l'autre disque central (40') sont prévus des prolongements de canaux (43') qui représentent des zones ne se trouvant pas sur le trajet d'écoulement le plus court allant des ouvertures d'entrée (36) aux ouvertures de sortie (38).

11. Disque perforé selon la revendication 1,
**caractérisé en ce que**
le disque perforé (23) est formé de cinq disques, l'au moins un canal (42, 42') s'étendant dans un des disques centraux (40) tandis que, dans les deux autres disques centraux (40'), sont prévus des prolongements de canaux (43') qui représentent des régions ne se trouvant pas sur le trajet d'écoulement le plus court allant des ouvertures d'entrée (36) aux ouvertures de sortie (38).

12. Disque perforé selon une des revendications précédentes,
**caractérisé en ce que**
dans au moins un des disques centraux (40, 40') est disposé, en s'engageant, au moins un trébuchet (50) sous l'effet duquel un courant qui le franchit dans le canal (42, 42') forme une traine de tourbillons.

13. Procédé de fabrication d'un disque perforé (23) en particulier d'un disque perforé pour injecteurs, qui présente un passage complètement débouchant pour un fluide, au moins une ouverture d'entrée (36) et au moins une ouverture de sortie (38), chaque ouverture d'entrée (36) étant formée dans un disque supérieur (35) du disque perforé (23) et chaque ouverture de sortie (38) étant formée dans un disque inférieur (37) du disque perforé (23), et au moins un disque central additionnel (40, 40') interposé entre le disque supérieur (35) et le disque inférieur (37) présente au moins un canal (42, 42') représentant une liaison complète entre au moins une des ouvertures d'entrée (36) et au moins une des ouvertures de sortie (38),
**caractérisé en ce que**
le disque supérieur (35) est muni d'une pluralité d'ouvertures d'entrée (36) et le disque inférieur (37) d'une pluralité d'ouvertures de sortie (38), les ouvertures d'entrée (36) et les ouvertures de sortie (38) étant disposées de manière qu'elles ne se recouvrent en aucun endroit dans une projection sur un plan, et les ouvertures d'entrée (36) étant formées plus prés d'un axe médian (2) du disque perforé (23) que les ouvertures de sortie (38), de sorte qu'il existe un décalage radial dans la direction de l'écoulement vers l'extérieur, et que les ouvertures d'entrée (36), les ouvertures de sortie (38) et les canaux (42, 42') sont formés par érosion profonde, érosion au fil, coupe au laser ou découpage à la presse.
